# EUROPÄISCHE PATENTSCHRIFT

(11) **EP 3 636 054 B1**
(45) Veröffentlichungstag und Bekanntmachung des Hinweises auf die Patenterteilung: **16.02.2022**
(21) Anmeldenummer: 18722477.9
(22) Anmeldetag: 03.05.2018
(51) Int. Cl.: H05K 5/04, H05K 5/06, H05K 5/00, H02K 5/10

(54) **GEHÄUSE FÜR EIN ELEKTROGERÄT MIT EINEM DICHT ANGEFORMTEN GEHÄUSETEIL**
HOUSING FOR AN ELECTRICAL DEVICE, HAVING A TIGHTLY FITTING HOUSING PART
BOÎTIER POUR UN APPAREIL ÉLECTRIQUE POURVU D'UNE PARTIE DE BOÎTIER FORMÉE DE MANIÈRE ÉTANCHE

(30) Priorität: 08.06.2017 DE 102017209657
(43) Veröffentlichungstag der Anmeldung: 15.04.2020
(73) Patentinhaber: Robert Bosch GmbH, 70442 Stuttgart (DE)
(72) Erfinder: MOESSNER, Joerg, 72827 Wannweil (DE); SCHENK, Bjoern, 70199 Stuttgart (DE)
(86) Internationale Anmeldenummer: PCT/EP2018/061266
(87) Internationale Veröffentlichungsnummer: WO 2018/224217

(56) Entgegenhaltungen:
- EP-A1- 1 508 398
- EP-A1- 2 226 185
- DE-A1-102007 023 418
- DE-A1-102013 209 666
- FR-A1- 2 897 750

## Beschreibung

### Stand der Technik

Die Erfindung betrifft ein Gehäuse für ein Elektrogerät, insbesondere eine elektrische Maschine. Das Gehäuse umschließt einen Hohlraum. Das Gehäuse weist einen Gehäusebecher und ein Gehäuseteil auf. Das Gehäuseteil, welches beispielsweise durch ein Verschlusselement, insbesondere einen Gehäusedeckel gebildet ist, ist ausgebildet, mit dem Gehäusebecher insbesondere trennbar oder untrennbar verbunden zu werden oder den Gehäusebecher zu verschließen.

Die Dokumente EP 2 226 185 A1 und FR 2 897 750 A1 zeigen Gehäuse für Elektrogeräte mit einem Gehäusebecher mit einem Becherrand aus einem Metall sowie einem Kunststoffgehäuseteil, das mittels eines an den Becherrand angespritzten oder angeschmolzenen Adapters mit dem Becher verbunden ist.

### Offenbarung der Erfindung

Erfindungsgemäß weist der Gehäusebecher, insbesondere eine Gehäusewand des Gehäusebechers, eine Öffnung auf. Der Gehäusebecher ist wenigstens im Bereich eines um die Öffnung umlaufend ausgebildeten Gehäusebecherrandes aus Metall, insbesondere Stahl oder Aluminium, gebildet. Das Gehäuseteil ist aus Kunststoff gebildet. Das Gehäuse weist einen insbesondere röhrenförmigen Adapter zum Verbinden des Gehäusebechers mit dem Gehäuseteil auf. Der Adapter ist an einen Längsabschnitt des Gehäusebecherrandes angespritzt oder angeschmolzen. Der Adapter weist an einem zu dem Gehäusebecher entgegengesetzten Ende einen eine Adapteröffnung umschließenden, insbesondere stegförmigen Adapterrand auf, welcher ausgebildet ist, mit dem Gehäuseteil - insbesondere dicht - verklebt oder verschweißt zu werden. Durch den Adapter kann so vorteilhaft ein Gehäuseteil, welches ausgebildet ist, ein Steuergerät oder elektrische Komponenten aufzunehmen, mit dem Gehäusebecher dicht verbunden werden, wobei der Adapter beispielsweise zum Gehäuseteil hin im Bereich der Adapteröffnung eine insbesondere standardisierte Schnittstelle für den Gehäuseteil aufweist. Das Gehäuse, insbesondere der Gehäusebecher, kann so weiter vorteilhaft mittels des Gehäuseteils mediendicht verschlossen werden sodass an einer Fügestelle zwischen dem Gehäuseteil und dem Gehäusebecher keine Medien wie Wasser oder Öl ins Gehäuseinnere eindringen können.

Durch den Adapter kann sowohl ein zum Gehäusebecherrand weisender Adapterrand einen die Öffnung umschließenden Kurvenzug aufweisen, der so an die Form des Gehäuserandes - bevorzugt durch Schmelzformen des Adaptermaterials - angepasst ist. Unabhängig davon oder zusätzlich dazu kann der zu dem Gehäuseteil, insbesondere zu dem Verschlusselement weisende Adapterrand einen an das Gehäuseteil angepassten Kurvenzug aufweisen.

In einer bevorzugten Ausführungsform weist das Gehäuse, insbesondere die Gehäusewand, wenigstens eine Rundung auf. Beispielsweise ist das Gehäuse, bevorzugt wenigstens der Gehäusebecher, in einer einfachen Ausführungsform zylinderförmig ausgebildet. Weiter bevorzugt ist der Gehäusebecher durch einen zylinderförmigen Gehäusebecher, insbesondere Metallbecher, gebildet. Das Gehäuse selbst kann so - insbesondere als Gehäuse eines Elektromotors - stabil ausgebildet sein, wobei das Gehäuseteil, beispielsweise ein Gehäusedeckel zur Aufnahme eines Steuergeräts, aus Kunststoff ausgebildet ist und so mit einem geringen Gewicht und aufwandsgünstig bereitgestellt werden kann.

In einer anderen Ausführungsform ist das Gehäuse und/oder der Gehäuserand mehreckig oder Polygonförmig ausgebildet. Der Adapter kann vorteilhaft durch das Angeformtwerden an den Gehäuserand eine dichte schraubgewindefreie Verbindung auch mit nicht rotationssymmetrischen Gehäuserandformen ausbilden.

In einer bevorzugten Ausführungsform weist der Gehäusebecherrand zum Adapter hin einen die Öffnung umspannenden Kurvenzug auf, der wenigstens eine Rundung und/oder wenigstens eine Ecke aufweist.

Bevorzugt ist der Adapter zu dem Gehäusebecherrand entsprechend ausgebildet, wobei der Adapterrand einen geschlossen Kurvenzug ausbildet.

Vorteilhaft kann der Adapter so ein Gerätegehäuse, gebildet durch das Gehäuseteil, beispielsweise für ein Steuergerät, an eine Vielzahl von Metallgehäusebecherformen und Gehäusebechergrößen adaptieren. Vorteilhaft kann auch das Verschlusselement den Gehäusebecher mittels des Adapters dicht verschließen, da ohne den Adapter die Abdichtung zwischen den Verschlusselement und den Gehäuse sonst eine Schwachstelle bilden kann.

In einer bevorzugten Ausführungsform ist die Öffnung des Adapters zum Gehäuseteil bevorzugt dem Gehäusedeckel hin rund, insbesondere kreisrund, ausgebildet. Das Gehäuseteil lässt sich so einfach und dicht schließend auf die Adapteröffnung aufsetzen, und mit dem Adapter verkleben oder verschweißen. Beispielsweise kann der Adapter ein Gehäuseteil mit einer runden Öffnung an ein eckiges Gehäuse adaptieren.

In einer bevorzugten Ausführungsform weist der Längsabschnitt des Gehäusebecherrandes insbesondere durch Fräsen erzeugte Ausnehmungen oder insbesondere mittels Laserstrahlen erzeugte Vertiefungen auf. Bevorzugt greift der Adapter, insbesondere das Adaptermaterial, formschlüssig in die Ausnehmungen oder Vertiefungen ein.

Die Ausnehmungen oder Vertiefungen sind bevorzugt mittels Laserstrahlen erzeugt. So kann der Adapter vorteilhaft formschlüssig und weiter vorteilhaft dicht mit dem Metallgehäuse fest verbunden werden. Vorteilhaft können so durch Umschmelzvorgänge hervorstehende Überstrukturen und Hinterschnitte in dem Gehäuserand erzeugt werden.

Die Ausnehmungen oder Vertiefungen sind beispielsweise mittels Materialentfernung oder Materialumformen, insbesondere Laserschmelzen, Schneiden oder Fräsen, oder chemisches Ätzen erzeugt. Die Vertiefungen können beispielsweise eine Tiefenerstreckung zwischen 5 und 500 Mikrometer aufweisen.

Die mittels Laserstrahlen, insbesondere gepulsten Laserstrahlen erzeugten Strukturen, umfassend Vertiefungen oder zusätzlich Erhebungen, weisen beispielsweise eine Tiefe insbesondere quer zur Oberfläche des Gehäuserandes zwischen 150 und 500 Mikrometern auf. Bevorzugt sind durch die Laserstrahlen eine Struktur erzeugt, die eine Kombination aus zueinander benachbart und einander überlappend angeordneten Erhebungen und Vertiefungen gebildet ist, so dass damit hierdurch eine Vielzahl von geometrischen Hinterschnitten gebildet sind.

Ein Verfahren zum Erzeugen der Vertiefungen ist beispielsweise in der DE 10 2007 023 418 A1 beschrieben.

In einer bevorzugten Ausführungsform ist durch die Ausnehmungen oder Vertiefungen in der Ebene des Gehäuserandes ein Muster, insbesondere Taumelmuster gebildet. Das Taumelmuster umfasst bevorzugt einen Kurvenzug oder mehrere Kurvenzüge. Dazu kann beispielsweise der Laser oder Fräswerkzeug beim Eindringen in den Gehäuserand des Gehäuses insbesondere in taumelnden Kreisbewegungen in zueinander verschiedene Richtungen innerhalb des Längsabschnitts des Gehäuserandes fahren, wobei das Gehäuse entlang einer Längserstreckung beim Umschmelzen durch den Laserstrahl gedreht wird und/oder der Laserstrahl um den Gehäuserand herumbewegt wird. Mittels des Taumelmusters kann bevorzugterweise bei den durch die Vertiefungen gebildeten Kurvenzügen des Taumelmusters keine Vorzugsausrichtung ausgebildet sein.

In einer bevorzugten Ausführungsform des Gehäuses ist der Adapter im Bereich des Adapterrandes mit dem Gehäuseteil mittels eines Heißfügeverfahrens, beispielsweise Infrarotschweißen, Heißgasschweißen, Heizspiegelschweißen, Ultraschallschweißen oder Laserschweißen, insbesondere Laserdurchstrahlschweißen, verbunden. Dadurch ist das Gehäuseteil mit dem Gehäusebecher insbesondere untrennbar verbunden.

Der Adapter ist wenigstens im Bereich des Adapterrandes durch einen Kunststoff gebildet, welcher ausgebildet ist, Laserstrahlen, insbesondere Infrarotstrahlen, nur wenig oder nicht zu absorbieren, so dass der Adapter im Bereich der Adapterrandes, welcher einen Verbindungsabschnitt zum Verbinden mit dem Gehäusedeckel bildet, für die Laserstrahlen transluzent ausgebildet ist. Die Laserstrahlen können so durch den Adapterrand transmittieren und auf das Gehäuseteil treffen, und dort absorbiert werden. Das Gehäuseteil, beispielsweise der Gehäusedeckel, kann so mit dem Adapterrand verschmelzen.

Die Laserstrahlen zum Erzeugen der Struktur, insbesondere Vertiefungen und/oder Ausnehmungen sind bevorzugt gepulste Laserstrahlen, bevorzugt mit Pulsen im Bereich von Nanosekunden, bevorzugt zwischen 20 und 50 Nanosekunden. Die Wellenlänge der Laserstrahlen beträgt bevorzugt zwischen 1000 und 1200 Nanometer, besonders bevorzugt 1030 Nanometer. Die Laserstrahlen sind bevorzugt ausgebildet das Material des Gehäuses aufzuschmelzen und umzuformen. Die Struktur kann vorteilhaft ein in der Ebene des Gehäuserandes gebildetes Muster sein. Dadurch können im Bereich der Vertiefungen auch zu den Vertiefungen benachbarte Schmelzwulste erzeugt werden, die von dem Adaptermaterial zur Ausbildung eines Formschlusses umschlossen und so eingebettet werden können. Vorteilhaft kann das Adaptermaterial während des Geformtwerdens, insbesondere beim Spritzgießen oder beim Heißumformen in die Hinterschnitte der Oberflächenstruktur des Gehäuserandes eindringen und so einen insbesondere mehrdimensionalen Formschluss erzeugen und so eine feste Verbindung zwischen dem Adapter und dem Gehäuserand erzeugen. Eine Dichtheit zwischen dem Adapter und dem Gahäuserand wird so über ein durch die Oberflächenstruktur gebildetes Labyrinth erreicht, indem ein Leckagepfad für Medien durch zahlreiche Umlenkung an den Hinterschnitten im Kontaktbereich zwischen dem Adapter und dem Gehäuserand ausreichend lang ausgebildet ist. Bevorzugt ist an dem Gehäuseteil ein umlaufender Vorsprungsbereich, insbesondere Ring, Steg oder Wulst ausgebildet. Der Vorsprungsbereich ist ausgebildet, Laserstrahlen, insbesondere Infrarotstrahlen zu absorbieren und dabei zu schmelzen. Der Gehäusedeckel kann somit Übermaß in die Adapteröffnung eingepresst werden. Der Vorsprungsbereich kann dann von außen durch einen insbesondere radial nach innen gerichteten Laserstrahl schmelzen und so mit dem Adapter verbunden werden. Die Verbindung zum Adapter ist beispielsweise eine stoffschlüssige oder eine Klebeverbindung. Beim Schmelzen des Vorsprungsbereiches kann die Pressspannung durch Schmelzaustrieb abgebaut werden. Die Pressspannung dient so vorteilhaft als unterstützende Fügekraft während des Schweißvorgangs.

Der Adapter ist aus zueinander verschiedenen Kunststoffen gebildet, wobei der Adapterrand aus einem zum Laserdurchstrahlschweißen ausgebildeten Kunststoff gebildet ist und ein mit dem Gehäuserand verbundener Haltabschnitt des Adapters aus einem faserverstärkten Kunststoff gebildet ist. Die Fasern sind beispielsweise Glasfasern. Die Glasfasern sind bevorzugt derart kurz ausgebildet, dass sie in die vorgenannten Vertiefungen wenigstens mit einem Längsabschnitt oder vollständig eindringen können.

Der Adapterrand ist bevorzugt zum Zusammenfügen mit dem Gehäuseteil ausgebildet, wobei der Adapterrand eine Fügestelle ausbildet. Bevorzugt bildet ein Öffnungsrand des Adapterrandes einen geschlossenen Linienzug aus, wobei eine Öffnung des Gehäuseteils dazu entsprechend geformt ist, so dass das Gehäuseteil und der Adapter im Bereich des Adapterrandes miteinander dicht aneinanderschließen.

Das Elektrogerät ist bevorzugt eine elektrische Maschine. Das Gehäuseteil ist bevorzugt ausgebildet, ein Steuergerät für die elektrische Maschine oder elektrische Komponenten des Elektrogeräts aufzunehmen.

Die Erfindung betrifft auch ein Verfahren zum Verbinden eines Gehäuseteils, insbesondere eines Gehäusedeckels mit einem Gehäusebecher, wobei der Gehäusebecher wenigstens im Bereich eines um eine Öffnung umlaufend ausgebildeten Gehäusebecherrandes aus Metall gebildet ist.

Bei dem Verfahren werden in einer Gehäusewand des Gehäusebechers mittels Laserstrahlen Ausnehmungen erzeugt. In einem weiteren Schritt wird an das Gehäuse, insbesondere einen Gehäusebecherrand des Gehäusebechers ein Kunststoffadapter angeformt, wobei der Kunststoff in die Ausnehmungen und/oder die Hinterschnitte eindringt und den Adapter so mit dem Gehäusebecher fest und dicht verbindet.

An dem Adapter ist oder wird ein die Adapteröffnung umschließender Adapterrand ausgebildet. Der Adapter ist aus zueinander verschiedenen Kunststoffen gebildet, wobei der Adapterrand aus einem zum Laserdurchstrahlschweißen ausgebildeten Kunststoff gebildet ist und ein mit dem Gehäusebecherrand verbundener Haltabschnitt des Adapters aus einem faserverstärkten Kunststoff gebildet ist.

J Der Adapterrand wird in einem weiteren Schritt mit dem Gehäuseteil - beispielsweise wie zuvor am Beispiel des Verschweißens beschrieben - verbunden, und das Gehäuse so insbesondere flüssigkeitsdicht und/oder gasdicht verschlossen. Die elektrische Maschine, insbesondere der Elektromotor und/oder Generator, ist so gegenüber einer Flüssigkeit, insbesondere Medien wie Öl oder Wasser, abgedichtet.

Bevorzugt wird bei dem Verfahren, insbesondere vor einem Anformen des Adapters an den Gehäusebecher, mittels der Laserstrahlen in der Gehäusewand durch Materialumschmelzen Vertiefungen, Hinterschnitte oder zusätzlich Vorsprünge, insbesondere Wulste erzeugt, so dass der Adapter beim Angeformtwerden an den Gehäuserand mit dem Gehäuse formschlüssig verbunden werden kann. Vorteilhaft ist der Adapter so mit dem Gehäuse drehfest und/oder Zugfest verbunden. Vorteilhaft können so auch thermische Ausdehnungen des Gehäuses, insbesondere verursacht durch zueinander verschiedene Ausdehnungskoeffizienten des Adapters und der Gehäusewand, den Adapter nicht von dem Gehäuserand lösen.

In einer bevorzugten Ausführungsform werden das Gehäuseteil oder der Gehäusedeckel und der Adapterrand des Adapters mittels Laserstrahlen miteinander verschweißt.

Dadurch ist das Gehäuseteil oder der Gehäusedeckel mit dem Adapter flüssigkeitsdicht und/oder gasdicht verbunden. Bevorzugt weisen das Gehäuseteil, insbesondere der Gehäusedeckel, und der Adapter den gleichen thermischen Ausdehnungskoeffizienten auf. Vorteilhaft kann die Schweißstelle zwischen dem Gehäuseteil und dem Adapter auch bei thermischer Belastung nicht aufreißen, so dass das Gehäuseteil mit dem Adapter stoffschlüssig und rissfest, und somit dicht verbunden ist.

Die Erfindung wird nun im Folgenden anhand von Figuren und weiteren Ausführungsbeispielen beschrieben. Weitere vorteilhafte Ausführungsvarianten ergeben sich aus einer Kombination der in den Figuren und/oder in den abhängigen Ansprüchen beschriebenen Merkmale.
Figur 1 zeigt ein Ausführungsbeispiel für ein elektrisches Gerät, bei dem ein Gehäusebecher mittels eines an den Gehäusebecher angespritzten Adapters mit einem Gehäusedeckel verbunden ist;
Figur 2 zeigt mittels Laserstrahlen erzeugte Vertiefungen und Hinterschnitte in einem Gehäuserand.

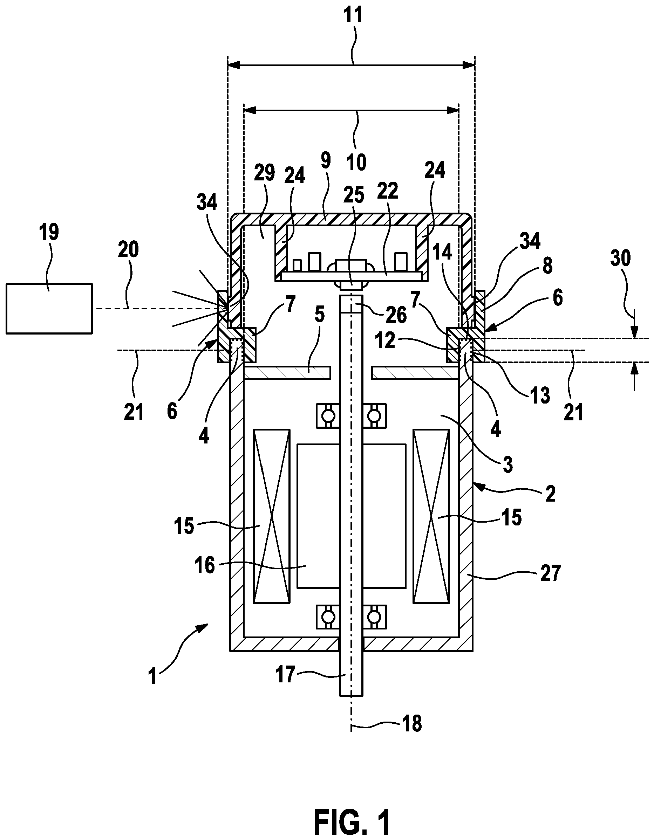

Figur 1 zeigt - schematisch - ein Ausführungsbeispiel für ein elektrisches Gerät 1, in diesem Ausführungsbeispiel eine elektrische Maschine, insbesondere ein Generator oder ein Elektromotor. Das Gerät 1 weist ein Gehäuse 2 auf, welches in diesem Ausführungsbeispiel einen Gehäusebecher 27 aufweist. Das Gehäuse 2 umschießt einen Hohlraum 3. In dem Hohlraum 3 ist in diesem Ausführungsbeispiel der Elektromotor aufgenommen, von dem ein Stator 15 und ein Rotor 16 dargestellt sind. Eine Rotorwelle 17 des Rotors 16 erstreckt sich entlang einer Längsachse 18 des elektrischen Gerätes 1.

Der Gehäusebecher 27, welcher in diesem Ausführungsbeispiel durch einen Metallgehäusebecher, insbesondere Aluminiumgehäusebecher, gebildet ist, weist einen Gehäusebecherrand 4 auf, welcher eine Öffnung 10 zu dem Hohlraum 3 hin umschließt. Das Gehäuse 2 weist auch einen Gehäusedeckel bildendendes Gehäuseteil 9 auf, welches ausgebildet ist, elektrische Komponenten des Geräts 1 aufzunehmen.

In diesem Ausführungsbeispiel ist an eine Gehäusewand des Gehäusebechers 27 eine sich quer, und so radial nach innen, erstreckende Trennwand 5 angeformt. Die Trennwand 5 trennt den Hohlraum 3, in dem der Elektromotor aufgenommen ist, von einem Hohlraum 29, welcher von dem Gehäuseteil 9 umschlossen ist. Das Gehäuseteil 9 bildet in diesem Ausführungsbeispiel auch ein Verschlusselement, das ausgebildet ist, die Öffnung 10 zu verschließen. In dem Hohlraum 29 ist in diesem Ausführungsbeispiel ein Steuergerät 22 als elektrische Komponente des Geräts 1 aufgenommen. Das Steuergerät 22 ist von einem Steg 24 gehalten, welcher an das Gehäuseteil 9 angeformt ist. Das Steuergerät 22 weist in diesem Ausführungsbeispiel einen Rotorlagesensor 25 auf, welcher im Wirkbereich eines Endabschnittes 26 der Rotorwelle 17 angeordnet ist. Der Rotorlagesensor 25 ist beispielsweise ein Hallsensor, ein GMR-Sensor (GMR = Giant-Magneto-Resistive) oder ein AMR-Sensor (AMR = Anisotrope-Magneto-Resistive). Der Endabschnitt 26 weist beispielsweise einen Permanentmagnet auf, so dass der Rotorlagesensor 25 eine Rotorposition des Rotors 16 erfassen kann und ein entsprechendes Rotorpositionssignal zum Ansteuern des Stators 15 durch das Steuergerät 22 erzeugen kann.

Das Gehäuse 2 weist auch einen Adapter 6 auf. Das Gehäuseteil 9, welches durch ein Kunststoff-Gehäuseteil gebildet ist, ist mittels des Adapters 6 mit dem Gehäusebecher 27 verbunden.

Der Adapter 6 ist in diesem Ausführungsbeispiel durch einen Adapterring gebildet, welcher an den Gehäusebecherrand 4 angespritzt ist. Der Adapter 6 weist dazu einen Halteabschnitt 7 auf, welcher ausgebildet ist, den Gehäusebecherrand 4 des Gehäusebechers 27 auf einem Längsabschnitt 30 zu umgreifen. Der Längsabschnitt 30 erstreckt sich entlang der Längsachse 18.

Der Gehäusebecherrand 4 weist auf dem Längsabschnitt 30 mittels Laserstrahlen erzeugte Vertiefungen, Hinterschnitte, oder Vorsprünge, insbesondere hervorstehende Schmelzwulste auf.

An dem Gehäusebecherrand 4 sind an einer radial nach innen weisenden Oberfläche des Gehäusebecherrandes 4 Vertiefungen 12 ausgebildet. An einer dazu gegenüberliegenden, nach außen weisenden Oberfläche sind Vertiefungen 13 ausgebildet. An einer Stirnseite des Gehäusebecherrandes 4 sind Vertiefungen 14 ausgebildet. Die Vertiefungen 12, 13 und 14 sind beispielsweise mittels Laserstrahlen erzeugt. Die Vertiefungen bilden gemeinsam ein Vertiefungsmuster, welches in der Ebene des Gehäusebecherrandes 4 beispielsweise ein Taumelmuster bildet. Ein den Adapter 6 bildendes Kunststoffmaterial ist - insbesondere im Bereich des Halteabschnitts 7 - beim Erzeugen, beispielsweise beim Anspritzen des Adapters 6 in die Vertiefungen eingedrungen und hat diese ausgefüllt. Der Adapter 6 ist so mit dem Gehäusebecherrand 4 fest verzahnt verbunden. Das Kunststoffmaterial des Adapters 6 greift so in die Vertiefungen ein.

Zusätzlich zu den Vertiefungen können dazu benachbart Schmelzwulste durch die Laserstrahlen erzeugt werden, die von dem Kunststoffmaterial umschlossen werden können und der Adapter 6 so an den Schmelzwulsten zusätzlich festhalten kann. Die Vertiefungen können an einer Innenseite, an einer Stirnseite oder an einer Außenseite oder einer Kombination der Seiten an dem Gehäusebecherrand 4 ausgebildet sein.

Der Adapter 6, in diesem Ausführungsbeispiel ein Adapterring, weist einen an den Halteabschnitt 7 angeformten Verbindungsabschnitt 8 auf, welcher in diesem Ausführungsbeispiel ringförmig, insbesondere hohlzylinderförmig ausgebildet ist. Der Verbindungsabschnitt 8 bildet den zuvor erwähnten Adapterrand.

Wie bereits erwähnt kann der Adapter in einer anderen Ausführungsform nicht rotationssymmetrisch ausgebildet sein, und dazu beispielsweise einen Halteabschnitt zum Umgreifen des Gehäusebecherrandes 4 aufweisen, der - entsprechend dem Gehäuserand - einen geschlossenen Kurvenzug bildet. Der Kurvenzug kann runde Abschnitte und/oder eckige Abschnitte aufweisen.

Der Verbindungsabschnitt 8 erstreckt sich in Richtung der Längsachse 18 und ist ausgebildet, mit dem Gehäuseteil 9 mittels Laserstrahlen 20 verschweißt zu werden. Dargestellt ist auch ein Laser 19, welcher ausgebildet ist, die Laserstrahlen 20 zu erzeugen. Der Verbindungsabschnitt 8 des Adapters 6 ist dazu für die Laserstrahlen transluzent ausgebildet, sodass die Laserstrahlen 20 den Adapter 6 wenigstens im Bereich des Verbindungsabschnitts 8 durchdringen können, ohne dass die Laserstrahlen 20 wesentlich absorbiert werden. Die Laserstrahlen 20 können dann nach einem Durchdringen des Verbindungsabschnitts 8 auf den Rand des Gehäusedeckels 9 treffen und dort das Gehäuseteil 9 anschmelzen, sodass der Gehäusedeckel 9 und der Verbindungsabschnitt 8 des Adapters 6 miteinander schmelzverbunden werden können.

Das Gehäuse 2 kann so vor einem Eindringen von Feuchtigkeit oder Öl geschützt und dazu dicht verschlossen werden.

Der Verbindungsabschnitt 8 und der Halteabschnitt 7 sind aus zueinander verschiedenen Kunststoffen, bevorzugt Thermoplasten gebildet. Der Verbindungsabschnitt 8 ist aus einem für Laserstrahlen 20 transluzenten Kunststoff gebildet, und der Verbindungsabschnitt aus einem faserverstärkten, insbesondere mittels Glasfasern oder Kohlefasern verstärkten Kunststoff gebildet, welcher einen ähnlichen thermischen Ausdehnungskoeffizienten aufweist wie das Metall des Gehäuses 2.

Der Adapter 6 kann dazu beispielsweise mittels Mehrkomponenten-Spritzgießen erzeugt sein, bei dem die Komponenten insbesondere stoffschlüssig miteinander verbunden werden.

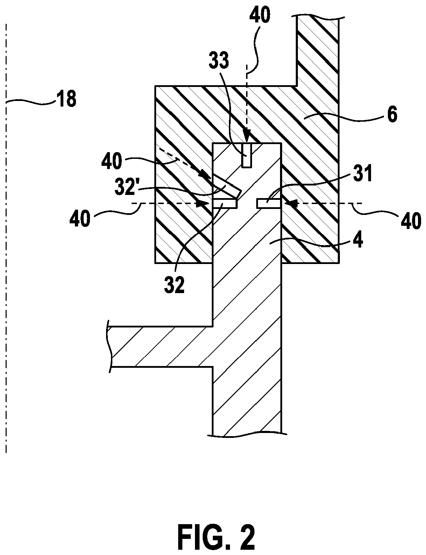

Figur 2 zeigt - schematisch - den in Figur 1 bereits dargestellten Gehäuserand 4, wobei mittels des Laserstrahls 40 erzeugte Vertiefungen detailliert dargestellt sind. Eine Vertiefung 31 erstreckt sich zu einer nach außen weisenden Oberfläche des Gehäusebecherrandes 4 orthogonal, sodass der Laserstrahl 40 beim Erzeugen des Vertiefungsmusters orthogonal auf die Oberfläche des Gehäusebecherrandes 4 auftreffen kann. Eine an einer nach innen weisenden Oberfläche erzeugte Vertiefung 32 verläuft quer zur Längsachse 18. In einer Variante verläuft eine Ausnehmung 32' schräg zur nach innen weisenden Oberfläche des Gehäusebecherrandes 4. Dadurch kann der Adapter 6, insbesondere der Halteabschnitt 7, formschlüssig durch den so erzeugten Hinterschnitt mit dem Gehäusebecherrand 4 verbunden werden.

An der Stirnseite des Gehäusebecherrandes 4, an der im Beispiel der Figur 1 die Vertiefungen 14 ausgebildet sind, ist in Figur 3 beispielhaft eine Vertiefung 33 ausgebildet, welche orthogonal zur Stirnseitenoberfläche, und so parallel zu der Längsachse 18, mittels des Laserstrahls 40 ausgeformt ist. In einer Variante kann die Vertiefung schräg zur Oberfläche der Stirnseite erzeugt sein, so dass ein Hinterschnitt gebildet ist, und das Kunststoffmaterial beim Ausbilden des Adapters 6 in die Vertiefung einfließen kann. Der Hinterschnitt kann zusätzlich oder unabhängig von dem schräg auf die Oberfläche treffenden Laserstrahl durch einen Schmelzwulst gebildet sein, der die Vertiefung überragt oder in die Vertiefung hineinragt. Durch die so gebildete Verzahnung ist der Adapter 6 fest mit dem Gehäuse 4 formschlüssig verbunden.

## Patentansprüche

1. Gehäuse (2) für ein Elektrogerät (1), insbesondere elektrische Maschine oder Elektromotor,
wobei das Gehäuse (2) einen Hohlraum (3) umschließt und das Gehäuse (2) einen Gehäusebecher (27) und ein Gehäuseteil (9) aufweist, das ausgebildet ist, mit dem Gehäusebecher (27) insbesondere fest verbunden zu werden oder das Gehäuse zu verschließen,
wobei der Gehäusebecher (27) eine Öffnung (10) aufweist, und der Gehäusebecher (27) wenigstens im Bereich eines um die Öffnung (10) umlaufend ausgebildeten Gehäusebecherrandes (4) aus Metall, insbesondere Aluminium gebildet ist, und das Gehäuseteil (9) aus Kunststoff gebildet ist, und das Gehäuse (2) einen insbesondere röhrenförmigen Adapter (6) zum Verbinden des Gehäusebechers (27) mit dem Gehäuseteil (9) aufweist, wobei der Adapter (6) an einen Längsabschnitt (30) des Gehäusebecherrandes (4) angespritzt oder angeschmolzen ist und der Adapter (6) an einem zu dem Gehäusebecher (27) entgegengesetzten Ende einen eine Adapteröffnung (11) umschließenden Adapterrand (8) aufweist, welcher ausgebildet ist, mit dem Gehäuseteil (9) insbesondere dicht verklebt oder verschweißt zu werden,
**gekennzeichnet dadurch,**
**dass**
der Adapter (6) aus zueinander verschiedenen Kunststoffen gebildet ist, wobei der Adapterrand (8) aus einem zum Laserdurchstrahlschweißen ausgebildeten Kunststoff gebildet ist und ein mit dem Gehäusebecherrand (4) verbundener Haltabschnitt (7) des Adapters (6) aus einem faserverstärkten Kunststoff gebildet ist.

2. Gehäuse (2) nach Anspruch 1,
**dadurch gekennzeichnet, dass**
das Gehäuse (2), insbesondere der Gehäusebecher (27) zylinderförmig ausgebildet ist.

3. Gehäuse (2) nach Anspruch 1 oder 2,
**dadurch gekennzeichnet, dass**
die Öffnung (11) des Adapters (6) zum Gehäuseteil (9) hin rund ausgebildet ist.

4. Gehäuse (2) nach einem der vorhergehenden Ansprüche,
**dadurch gekennzeichnet, dass**
der Längsabschnitt des Gehäusebecherrandes (4) mittels Laserstrahlen (40) erzeugte Vertiefungen (12, 13, 14, 31, 32, 33) und/oder Hinterschnitte aufweist, in die das Adaptermaterial eingeflossen ist und in die der Adapter so formschlüssig eingreift.

5. Gehäuse (2) nach einem der vorhergehenden Ansprüche,
**dadurch gekennzeichnet, dass**
der Gehäusebecherrand (4) zum Adapter (6) hin einen die Öffnung (10) umspannenden Kurvenzug aufweist, der wenigstens eine Rundung und/oder wenigstens eine Ecke aufweist.

6. Gehäuse (2) nach einem der vorhergehenden Ansprüche,
**dadurch gekennzeichnet, dass**
der Adapter (6) im Bereich eines Adapterrandes (8) mit dem Gehäuseteil (9) mittels Laserschweißen, insbesondere Laserdurchstrahlschweißen verbunden ist.

7. Verfahren zum Verbinden eines Gehäuseteils, insbesondere eines Gehäusedeckels, mit einem Gehäusebecher (27), bei dem in einer Gehäusewand des Gehäusebechers (27) mittels Laserstrahlen (20) Vertiefungen oder zusätzlich Hinterschnitte (12, 13, 14, 31, 32, 33) erzeugt werden, und an den Gehäusebecher (27) ein Adapter (6), nämlich Kunststoffadapter angeformt wird, wobei der Kunststoff des Adapters (6) in die Vertiefungen (12, 13, 14, 26, 27, 28) eindringt und den Adapter (6) so mit dem Gehäusebecher (27) fest verbindet, wobei der Gehäusebecher (27) wenigstens im Bereich eines um eine Öffnung (10) umlaufend ausgebildeten Gehäusebecherrandes (4) aus Metall gebildet ist,
und der Adapter (6) einen Adapterrand (8) aufweist und an dem Adapterrand (8) mit dem Gehäuseteil (9) verbunden wird, und der Gehäusebecher (27) so insbesondere dicht verschlossen wird, wobei der Adapter (6) aus zueinander verschiedenen Kunststoffen gebildet ist, wobei der Adapterrand (8) aus einem zum Laserdurchstrahlschweißen ausgebildeten Kunststoff gebildet ist und ein mit dem Gehäusebecherrand (4) verbundener Haltabschnitt (7) des Adapters (6) aus einem faserverstärkten Kunststoff gebildet ist.

8. Verfahren nach Anspruch 7,
bei dem mittels der Laserstrahlen (40) in der Oberfläche der Gehäusewand ein Taumelmustererzeugt wird.

9. Verfahren nach Anspruch 7 oder 8,
bei dem das Gehäuseteil (9) und der Adapterrand (4) des Adapters (6) mittels Laserstrahlen (20) miteinander verschweißt werden.

10. Verfahren nach Anspruch 9, bei dem mittels der Laserstrahlen (20) ein Vorsprungsbereich (34) an dem Gehäuseteil (9) geschmolzen wird, so dass dabei eine durch den Vorsprungsbereich (34) erzeugte Pressspannung abgebaut werden kann.

## Claims

1. Housing (2) for an electrical device (1), in particular electrical machine or electric motor, wherein the housing (2) encloses a cavity (3) and the housing (2) has a housing cup (27) and a housing part (9) which is formed to be in particular fixedly connected to the housing cup (27) and to close off the housing, wherein
the housing cup (27) has an opening (10) and the housing cup (27) at least in the region of a housing cup edge (4) formed circumferentially around the opening (10) is formed from metal, in particular aluminium, and the housing part (9) is formed from plastic, and the housing (2) has an in particular tubular adapter (6) for connection of the housing cup (27) to the housing part (9), wherein the adapter (6) is moulded or fused onto a longitudinal portion (30) of the housing cup edge (4) and the adapter (6) has, at an end opposite the housing cup (27), an adapter edge (8) surrounding an adapter opening (11), which adapter edge (8) is formed to be in particular tightly glued or welded to the housing part (9), **characterized in that**
the adapter (6) is formed from different plastics, wherein the adapter edge (8) is formed from a plastic formed for laser radiation welding and a holding portion (7) of the adapter (6) connected to the housing cup edge (4) is formed from a fibre-reinforced plastic.

2. Housing (2) according to Claim 1,
**characterized in that**
the housing (2), in particular the housing cup (27), is formed to be cylindrical.

3. Housing (2) according to Claim 1 or 2, **characterized in that**
the opening (11) of the adapter (6) is formed to be round toward the housing part (9).

4. Housing (2) according to any one of the preceding claims,
**characterized in that**
the longitudinal portion of the housing cup edge (4) has recesses (12, 13, 14, 31, 32, 33) and/or undercuts generated by means of laser beams (40), into which recesses and/or undercuts the adapter material has flowed and in which the adapter thus engages in a positivelocking manner.

5. Housing (2) according to any one of the preceding claims,
**characterized in that**
the housing cup edge (4) has a curve spanning the opening (10) toward the adapter (6), which curve has at least one rounding and/or at least one corner.

6. Housing (2) according to any one of the preceding claims,
**characterized in that**
the adapter (6) is connected in the region of an adapter edge (8) to the housing part (9) by means of laser welding, in particular laser radiation welding.

7. Method for connecting a housing part, in particular a housing cover, to a housing cup (27), in the case of which
recesses or additionally undercuts (12, 13, 14, 31, 32, 33) are generated by means of laser beams (20) in a housing wall of the housing cup (27), and an adapter (6), namely plastic adapter, is moulded onto the housing cup (27), wherein the plastic of the adapter (6) penetrates into the recesses (12, 13, 14, 26, 27, 28) and thus fixedly connects the adapter (6) to the housing cup (27), wherein the housing cup (27) at least in the region of a housing cup edge (4) formed circumferentially around an opening (10) is formed from metal,
and the adapter (6) has an adapter edge (8) and is connected to the housing part (9) at the adapter edge (8), and the housing cup (27) is thus in particular tightly closed off, wherein the adapter (6) is formed from different plastics, wherein the adapter edge (8) is formed from a plastic formed for laser radiation welding and a holding portion (7) of the adapter (6) connected to the housing cup edge (4) is formed from a fibre-reinforced plastic.

8. Method according to Claim 7,
in the case of which a whirl pattern is generated by means of the laser beams (40) in the surface of the housing wall.

9. Method according to Claim 7 or 8,
in the case of which the housing part (9) and the adapter edge (4) of the adapter (6) are welded to one another by means of laser beams (20).

10. Method according to Claim 9, in the case of which a projection region (34) is melted on the housing part (9) by means of the laser beams (20) so that a compressive tension generated by the projection region (34) can be reduced.

## Revendications

1. Boîtier (2) pour un appareil électrique (1), en particulier une machine métrique ou un moteur électrique, le boîtier (2) entourant une cavité (3) et le boîtier (2) comprenant un bac de boîtier (27) et une partie de boîtier (9) qui est réalisée pour être fixée en particulier solidement au bac de boîtier (27) ou pour fermer le boîtier,
le bac de boîtier (27) comprenant une ouverture (10), et le bac de boîtier (27) étant formée à partir de métal, en particulier d'aluminium, au moins dans la région d'un bord de bac de boîtier (4) réalisé de manière périphérique autour de l'ouverture (10), et la partie de boîtier (9) étant formée à partir de matière synthétique, et le boîtier (2) comprenant un adaptateur (6) en particulier tubulaire servant à la liaison du bac de boîtier (27) à la partie de boîtier (9), l'adaptateur (6) étant moulé par injection ou fondu sur une partie longitudinale (30) du bord de bac de boîtier (4) et l'adaptateur (6) comprenant, à une extrémité opposée au bac de boîtier (27), un bord d'adaptateur (8) entourant une ouverture d'adaptateur (11), lequel bord d'adaptateur est réalisé pour être collé ou soudé en particulier de manière étanche sur la partie de boîtier (9), **caractérisé en ce que**
l'adaptateur (6) est formé à partir de matières synthétiques différentes les unes des autres, le bord d'adaptateur (8) étant formé à partir d'une matière synthétique réalisée pour le soudage laser par transparence et une partie de retenue (7), reliée au bord de bac de boîtier (4), de l'adaptateur (6) étant formée à partir d'une matière synthétique renforcée par des fibres.

2. Boîtier (2) selon la revendication 1,
**caractérisé en ce que**
le boîtier (2), en particulier le bac de boîtier (27), est réalisé de manière cylindrique.

3. Boîtier (2) selon la revendication 1 ou 2, **caractérisé en ce que**
l'ouverture (11) de l'adaptateur (6) est réalisée de manière circulaire en direction de la partie de boîtier (9) .

4. Boîtier (2) selon l'une des revendications précédentes,
**caractérisé en ce que**
la partie longitudinale du bord de bac de boîtier (4) comprend des évidements (12, 13, 14, 31, 32, 33) et/ou des contre-dépouilles produits par le biais de faisceaux laser (40), dans lesquels la matière d'adaptateur s'est écoulée et dans lesquels l'adaptateur vient ainsi en prise par complémentarité de forme.

5. Boîtier (2) selon l'une des revendications précédentes,
**caractérisé en ce que**
le bord de bac de boîtier (4) comprend, en direction de l'adaptateur (6), une courbe s'étendant autour de l'ouverture (10), laquelle courbe comprend au moins un arrondi et/ou au moins un coin.

6. Boîtier (2) selon l'une des revendications précédentes,
**caractérisé en ce que**
l'adaptateur (6) est, dans la région d'un bord d'adaptateur (8), relié à la partie de boîtier (9) par soudage laser, en particulier par soudage laser par transparence.

7. Procédé de liaison d'une partie de boîtier, en particulier d'un couvercle de boîtier, à un bac de boîtier (27), dans lequel
des évidements ou en outre des contre-dépouilles (12, 13, 14, 31, 32, 33) sont produits dans une paroi de boîtier du bac de boîtier (27) par le biais de faisceaux laser (20), et un adaptateur (6), à savoir un adaptateur en matière synthétique, est façonné sur le bac de boîtier (27), la matière synthétique de l'adaptateur (6) pénétrant dans les évidements (12, 13, 14, 26, 27, 28) et reliant ainsi solidement l'adaptateur (6) au bac de boîtier (27), le bac de boîtier (27) étant formé à partir de métal au moins dans la région d'un bord de bac de boîtier (4) réalisé de manière périphérique autour de l'ouverture (10),
et l'adaptateur (6) comprend un bord d'adaptateur (8) et est relié à la partie de boîtier (9) au niveau du bord d'adaptateur (8), et le bac de boîtier (27) est ainsi fermé en particulier de manière étanche, l'adaptateur (6) étant formé à partir de matières synthétiques différentes les unes des autres, le bord d'adaptateur (8) étant formé à partir d'une matière synthétique réalisée pour le soudage laser par transparence et une partie de retenue (7), reliée au bord de bac de boîtier (4), de l'adaptateur (6) étant formée à partir d'une matière synthétique renforcée par des fibres.

8. Procédé selon la revendication 7,
dans lequel un motif de tourbillon est produit par le biais des faisceaux laser (40) dans la surface de la paroi de boîtier.

9. Procédé selon la revendication 7 ou 8,
dans lequel la partie de boîtier (9) et le bord (4) de l'adaptateur (6) sont soudés l'un à l'autre par le biais de faisceaux laser (20).

10. Procédé selon la revendication 9, dans lequel une région de saillie (34) est fondue sur la partie de boîtier (9) par le biais des faisceaux laser (20), de sorte qu'une contrainte de compression produite par la région de saillie (34) puisse ainsi être réduite.
